# EUROPEAN PATENT APPLICATION

(11) **EP 1 701 459 A1**
(43) Date of publication of application: **13.09.2006**
(21) Application number: 05005084.8
(22) Date of filing: 09.03.2005
(51) Int. Cl.: H04J 3/04, H03M 1/12

(54) **Method for data acquisition from multiple sources of analog signals**

(71) Applicant: Institute of Electronics and Computer Science of Latvian University, Riga, LV-1006 Latvia (LV)
(72) Inventor: Artjuhs, Jurijs, Riga LV1006 (LV); Bilinskis, Ivars, Riga LV-1006 (LV); Min, Mart, 13424 Tallin (EE); Strautmanis, Gundars, Riga LV-1067 (LV)
(74) Representative: Klickow, Hans-Henning

(57) **Abstract**

The method is used for digitizing of multiple analog signals and buffering or transmitting of digital replicas of such signals. The method comprises the conditioning of the analog signals and a digitizing of the conditioned analog signals. The digitizing comprises steps of generating of a periodic reference signal, generating of pulses at instants when each input signal crosses the reference signal in one direction, time division multiplexing of set pulses, sampling of the reference signal at sampling instants defined by the multiplexed pulses and quantizing of the obtained samples. After the digitizing the quantized samples are buffered or transmitted in a digital form.

## Description

The present invention relates generally to the field of digitising and processing of multiple sensor or signal inputs for data acquisition from multiple sources of analog signals for the purpose of monitoring, analysing and/or controlling systems and processes. More specifically the present invention is addressed to a problem of complexity and power consumption reducing for sensor nodes closely placed to the signal sources.

The method covered by the invention are applicable in a wide frequency range covering low frequency data acquisition from a very large number of sensors as well as data acquisition for multi-channel high frequency signal analysers.

Conventionally the data acquisition techniques are based on direct transmitting of analog signals from multiple distributed sensors to a central data acquisition block that sequentially performs
- conditioning of analog input signals;
- time division multiplexing of these signals;
- analog/digital (A/D) conversion of the multiplexed signal, including sampling of the signal at predetermined instants, and quantising of the samples;
- data buffering and/or transmitting for a further specific application.

There are a lot of data acquisition systems operating according to these principles. Typical example of such systems is a general-purpose USB-based DAQ module PMD-1208FS from "Measurement Computing". It provides 4 differential or 8 single-ended analog inputs, up to 12-bit A/D resolution, 50 kS/s sampling rate. However, most of similar data acquisition blocks have relatively large size and for this reason are located at a distance from the sensors and that leads to spurious distortions of the analog signals in the connecting lines. In addition, the number of analog inputs is usually limited to a few tens.

More advanced techniques for data acquisition use almost the same principles of operation but in this case each data acquisition block is implemented as a low power compact device (named "sensor node") that supports a wireless data transmitting. Typical example of such a sensor node is Multi-Channel Strain Transmitter from "StrainLink". It has the size of a postage stamp, needs only 8.7 mW powering (including RF link), supports 3 fully differential inputs, 10 bits A/D resolution, up to 1 kS/s sampling rate.

In the case of using the multiple sensor nodes, they can form so-called "wireless sensor network". Within such a network each separate sensor node might be located very close to some forming a group of sensors to avoid signal distortions in connecting lines. The total number of sensors within such a sensor network can be practically unlimited.

However, conceptually the sensor nodes and the data acquisition blocks as well must be self-contained fully completed devices since their basic operations are inseparable in terms of nearness of their physical interactions. For example, the theoretically separate sampling and quantisation operations of A/D conversion should be performed in a very close vicinity, typically within a single chip. All these mentioned facts lead to high technical complexity of the devices, they are of a relatively large size and they are characterised by substantial power consumption.

To avoid the mentioned limitations, the small-sized sensor nodes typically are designed using special microelectronic technologies that are oriented not only to high integration but also to very low power consumption. But the last requirement usually is related to significant restriction of the operating speed and decreasing of the total performance level.

Thus, the main problem is the reduction of the complexity of analog operations that must be performed close to the sensors. Resolution of this problem would lead to further reduction of the technical complexity of the related devices and, consequently, to reduction of their power consumption.

The present invention addresses the problem of complexity reducing for analog operations that must be performed close to the sensors by digitising of the conditioned analog signals by means of generating of a periodic reference signal, generating of pulses at instants when each input signal crosses said reference signal in one direction, time division multiplexing of said pulses, sampling of said reference signal at sampling instants defined by the multiplexed pulses, and quantising of the obtained samples. This results in the distributed multi-channel A/D conversion where a basic and more complex part of operation can be largely distanced form the sensors.

This invention provides a method for data acquisition from multiple sources of analog signals, comprising a conditioning of said analog signals and their following digitising that is performed in two distanced levels of operations. A periodic reference signal is generated so it is available both at the upper and lower levels. There is generating of pulses at instants when each input signal crosses said reference signal in one direction. Then the pulses are transmitted to the lower level using their time division multiplexing. At the lower the reference signal is sampled at sampling instants defined by the multiplexed pulses and the obtained analog samples are quantised. Obtained in this way digital presentation of the input signals is buffered and/or transmitted for further applications.

A primary object of the present invention is to provide a method to reduce complexity of analog operations that are performed close to the multiple sensors.

Another objects of the present invention are to provide methods to adapt the primary object to the specific requirements for input signal digitising in terms of relation between dynamic range and sampling rate.

In the figures there are shown examples of the invention. In detail it is described:
- Fig. 1: a block diagram illustrating a conventional procedure,
- Fig. 2: a block diagram according to the present invention,
- Fig. 3: a time diagram illustrating the manner in which input signals are converted to the pulse sequence at the upper level of A/D conversion and
- Fig. 4: a time diagram illustrating the manner in which the samples of input signals are obtained at the remote lower level of A/D conversion.

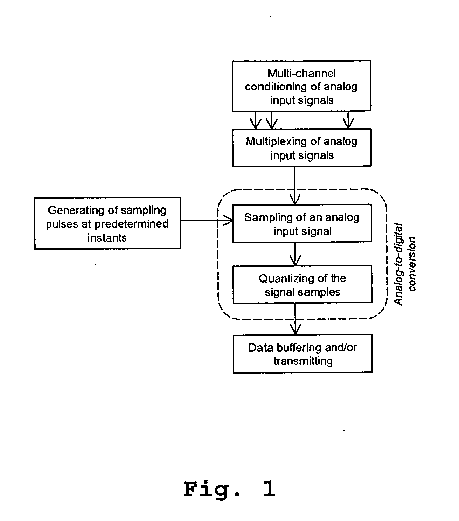

Fig.1 provides a simplified block diagram illustrating the manner in which the multiple input signals are digitised, buffered and/or transmitted for the conventional approach to data acquisition.

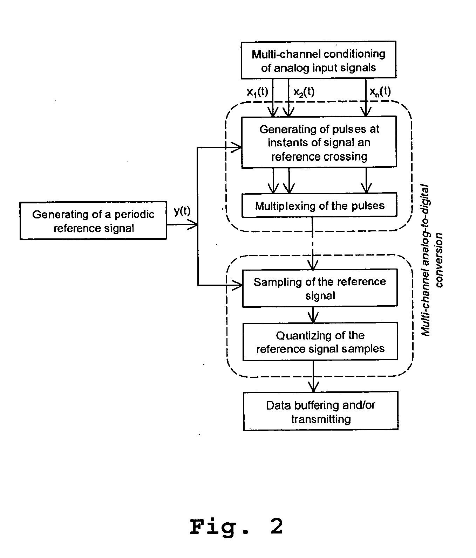

The block diagram of the present invention is presented in Figure 2. As compared to the Fig.1, the major difference is in the approach to the A/D conversions.

In the present invention all operations of the A/D conversion are divided into two interconnected physically distanced levels. Input signals [x₁(t), x₂(t), ... xₙ(t)] each are compared with a periodic reference signal y(t) at the upper level. In consequence of this, the sequences of pulses are generated in parallel at the time instants when the input signals cross either rising or falling part of the reference signal. Each of these pulses carries a sample value of the corresponding input signal directly related to the time instant of its generation.

Subsequent to this operation a time division multiplexing of said pulses is realised for alternative transmission of them to the lower level. In some cases the multiplexing of said pulses can be physically integrated with their generating by using, for example, controllable sequential enabling of the comparators detecting the time instants when signals cross the reference signal.

In general, the order of the pulse multiplexing can vary depending on the specific application. Along with the conventionally used sequential order, the pulse multiplexing can be performed also in a pseudo-random order. In this case it is possible to extend frequency bandwidth of input signals by using the known methods of digital alias-free processing of the non-uniformly sampled signals.

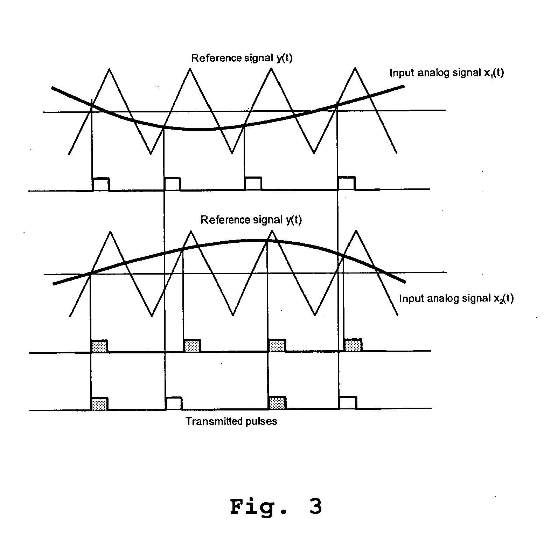

Figure 3 illustrates the above-mentioned operations in the case of a triangular waveform of the reference signal, two input analog signals and multiplexing the pulses in turn. Although the piecewise-linear reference waveforms are preferable to minimize possible nonlinear distortions, various other waveforms of the reference signal are acceptable, for example, sinusoidal.

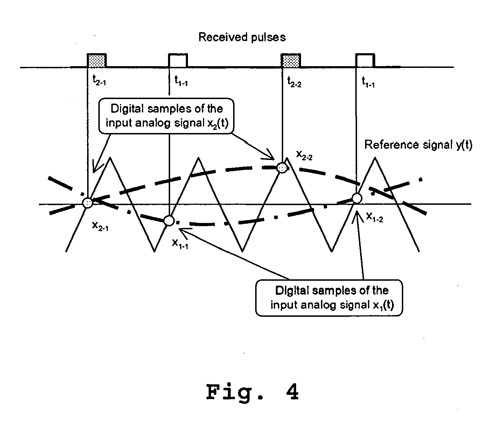

Sampling and quantising of the reference signal is performed at the lower level at the time instants of receiving said pulses. This results in presentation of each input analog signal in a form of a sequence of their digital, non-uniformly spaced sample values. In other words, each input analog signal xⱼ(t) is presented by a set of paired digital values {xⱼ₋ᵢ; tⱼ₋ᵢ} where the value tⱼ₋ᵢ is simply calculated from the predetermined reference signal waveform and the value xⱼ₋ᵢ. Figure 4 illustrates these final operations of A/D conversion as a continuation of the operations shown in Fig.3.

The above-mentioned sampling and quantising of the reference signal can be performed at the lower level either in real time by using either a typical A/D converter with the reference signal at its input or virtually. In the later case the sampling instants {tⱼ₋ᵢ} are measured and then the digital samples {xⱼ₋ᵢ} of the reference signal y(t) are calculated from its digital model y* (t) as {x_{j-I}=y*(t_{j-I})}. The first approach is better adapted to the reference signals generated at high frequencies since the maximum sample rate of the available A/D converters is high. However the dynamic range of the high-speed A/D converter is usually limited. The second approach is practically free from this limitation but is practicable for the reference signals generated at much lower frequencies since the maximum rate of time instant measurement is usually limited.

After A/D conversion, the digital replicas of the input signals are buffered and/or transmitted for a specific application. Note that the present invention results in non-uniform signal sampling that differs from the conventional periodic sampling of analog signals. However, this difference is not only acceptable, in many cases it even provides some essential advantages like elimination of aliasing.

As it follows from the explanations above, the present invention makes it possible to reduce the complexity of analog operations that are performed close to the sensors. They are replaced by remote sampling of the input signals realised as generation of pulses at the time instants when an input analog signal crosses the reference signal. It is crucial that such an operation is extremely simple and could be realised on the basis of typical analog signal comparators. Therefore each input signal then could be converted by a separate comparator without multiplexing the analog input signals.

Much simpler, faster and functionally flexible multiplexers of binary signals can be used in this case for realisation of the required multi-channel A/D conversions. This results in reducing both the technical complexity and the power consumption for the circuit (named "Sensor node") that is located near to the sensors. When the sensors are naturally subdivided into separate groups, the circuit supporting the upper level of operations can be also subdivided into separate Sensor nodes. A simplest Sensor node supports only a single sensor. Networking of such sensor nodes can be supported by their controllable actuation.

As for the operations of the lower level, they can be performed by a single circuit (named "Master node"). It can be greatly distanced from the Sensor nodes as qualitative transmitting of the pulses through a relatively long link is not problematic. In addition, the Master node can supply the Sensor nodes with the required power and the reference signal, generate an ancillary signals to control the Sensor nodes and synchronize their operation.

For some applications (such as biomedical), the Master node should be also reduced in size as far as possible to be located on a moving object. In this case the Master node can provide only minimum of operations that are necessary for operating the sensor nodes (such as reference signal generating, controlling and power supplying), and re-transmitting the pulses to a remote workstation using long-distance wire or a wireless link. Since the workstation is practically unlimited in size, it can have much better processing facilities (especially - PC-based workstations) to qualitatively present all input signals in a digital form and further processing them as required.

The method covered by the present invention can be embodied in various versions of apparatus depending on the specific requirements of application (number of sensors, their location and types, etc.). These versions can differ by specific topology of sensor network (star-structured, bus-structured, mixed), by means for reference signal generating and passing, pulse multiplexing, etc.

## Claims

1. A method for digitising of multiple analog signals and buffering or transmitting of digital replicas of said signals, said method comprising:
conditioning of said analog signals;
digitising of the conditioned analog signals by means of the following steps:
(a) generating of a periodic reference signal;
(b) generating of pulses at instants when each input signal crosses the said reference signal in one direction;
(c) time division multiplexing of said pulses;
(d) sampling of the said reference signal at sampling instants defined by the multiplexed pulses;
(e) quantizing of the obtained samples;
buffering and/or transmitting of said quantized samples in a digital form.

2. The method of claim 1, wherein said method is adapted to said reference signals generated at high frequencies; wherein said operations of sampling and quantizing are performed integrally as a typical A/D conversion of the reference signal actually providing the digital sample values of the input signal.

3. The method of claim 1, wherein said method is adapted to said reference signals generated at low frequencies; wherein said operations of sampling and quantizing are performed virtually by a measuring of the sampling instants and calculating of the digital samples of said reference signal from its digital model and the measured values of said sampling instants.

4. The method of claim 1, wherein said method is adapted to suppressing of aliasing; wherein said time division multiplexing is performed in a pseudo-random order.
